# FASCICULE DE BREVET EUROPEEN

(11) **EP 1 994 579 B1**
(45) Date de publication et mention de la délivrance du brevet: **27.04.2011**
(21) Numéro de dépôt: 07731059.7
(22) Date de dépôt: 27.02.2007
(51) Int. Cl.: H01L 51/52

(54) **DIODE ORGANIQUE ELECTROLUMINESCENTE A ELECTRODE TRANSPARENTE MULTI-COUCHE.**
ORGANISCHE LEUCHTDIODE MIT MEHRSCHICHTIGER TRANSPARENTER ELEKTRODE
ORGANIC LIGHT-EMITTING DIODE WITH A MULTILAYER TRANSPARENT ELECTRODE

(30) Priorité: 27.02.2006 FR 0650676
(43) Date de publication de la demande: 26.11.2008
(73) Titulaire: Commissariat à l'Énergie Atomique et aux Énergies Alternatives, 75015 Paris (FR)
(72) Inventeur: BETTINELLI, Armand, F-38500 Coublevie (FR); MICHELLYS, Jean-Yves, F-35235 Thorigni-Fouillard (FR); MARTINEZ, Jean-Claude, F-35131 Chartres de Bretagne (FR)
(74) Mandataire: Hecké, Gérard
(86) Numéro de dépôt international: PCT/FR2007/000357
(87) Numéro de publication internationale: WO 2007/096538

(56) Documents cités:
- EP-A- 1 076 368
- JP-A- 11 135 265
- US-A1- 2004 155 576
- US-A1- 2005 088 080
- FENG LI ET AL: "Electron injection and electroluminescence investigation of organic light-emitting devices based on a Sn/Al cathode" SYNTHETIC METALS, ELSEVIER SEQUOIA, LAUSANNE, CH, vol. 126, no. 2-3, 14 février 2002 (2002-02-14), pages 347-350, XP002405308 ISSN: 0379-6779 cité dans la demande

## Description

### Domaine technique de l'invention

L'invention concerne une diode organique électroluminescente à électrode transparente multi-couche, qu'elle soit inférieure, au contact direct du substrat, ou supérieure, à l'opposé du substrat par rapport à la couche électroluminescente.

### Etat de la technique

Dans le document US 2005/0088080, une électrode transparente présente une structure multi-couches dans l'ordre suivant: une couche d'injection LiF, une couche d'Al, une couche Ag, et un diélectrique TeO2.

Le document US5969474 décrit une diode organique électroluminescente comprenant :
- une couche organique intercalée entre une électrode inférieure au contact d'un substrat et une électrode supérieure transparente comprenant une première couche métallique, par exemple en alliage d'argent comme Mg-Ag, qui est au contact de la couche organique
- et une couche supérieure diélectrique transparente, formé par un oxyde transparent conducteur, comme de l'ITO ou de l'IZO, qui recouvre la première couche métallique.

Une couche tampon est intercalée entre la première couche métallique et la couche à base d'oxyde transparent conducteur, afin d'empêcher le métal de la couche métallique d'être oxydé à l'interface avec la couche d'oxyde transparent. La couche tampon est de préférence formée d'un métal tel que Ti, Cr, Ta, ou d'un nitrure de ces métaux ; son épaisseur est comprise entre 5 et 20 nm, de préférence entre 5 et 10 nm. De tels métaux (notamment Ti, Ta) sont particulièrement difficiles à déposer sous vide (température élevée de sublimation : 1600°C à 1700°C), ou (notamment Cr) sont susceptibles de détériorer les couches organiques sous-jacentes.

Le problème à résoudre est de fournir un matériau de couche tampon plus facile à déposer sous vide, d'apporter une meilleure protection contre l'oxydation, ou toute réaction équivalente de dégradation de la première couche métallique lorsqu'elle est spécifiquement à base d'argent. On a d'ailleurs constaté ce problème de dégradation avec d'autres oxydes que l'ITO ou l'IZO, comme par exemple avec le SiO, ou même avec des sulfures ou des séléniures.

Cette couche métallique d'argent de l'électrode supérieure a généralement trois fonctions: une fonction d'injection de charges dans la couche organique, une fonction de conduction électrique par le transport de charges, et une fonction réfléchissante ou semi-réfléchissante utile à former une cavité optique apte à améliorer l'extraction de lumière émise. Les charges en question sont généralement des électrons et cette électrode supérieure est alors une cathode.

La diode comprend généralement une couche inférieure apte à réfléchir la lumière émise par la couche électroluminescente ; cette couché est généralement formée par l'électrode inférieure. Ainsi, l'intervalle compris entre la couche inférieure réfléchissante et la première couche métallique à base d'argent de l'électrode supérieure, qui est au moins semi-réfléchissante, forme une cavité optique, qui, lorsqu'elle est ajustée en résonance d'une manière connue en elle-même, permet d'optimiser l'extraction de la lumière émise par la diode et même d'adapter les coordonnées chromatiques de la lumière extraite de la diode.

La couche supérieure diélectrique transparente de la diode a notamment pour but d'optimiser la cavité optique précédemment citée, en améliorant notamment la transparence de l'électrode supérieure, notamment dans le cas où l'épaisseur de la couche métallique de cette électrode est relativement importante (donc potentiellement absorbante) pour assurer une répartition efficace des charges. Un tel effet de diminution de l'absorption d'une couche métallique par adjonction d'une couche diélectrique est décrit notamment dans les documents EP1076368, EP1439589, EP1443572, US 2004/0155576. Ces documents décrivent des diodes émettant par une seule face, où est adjointe une couche diélectrique à l'une des électrodes transparentes (voir figure 4d dans EP1439589) ; cette couche diélectrique (référencée 22, en matériau ZnS : 20% SiO₂) a une fonction de réduction de l'absorption de la lumière émise au travers de l'électrode transparente ou semi-transparente à laquelle elle est adjointe. Or on a constaté que les matériaux diélectriques qui conviennent le mieux pour limiter l'absorption par une couche métallique sous-jacente en argent étaient souvent susceptibles de réagir avec l'argent. Or, les réactions chimiques à l'interface entre la couche métallique d'argent et la couche supérieure diélectrique transparente qui la recouvre sont susceptibles de détériorer d'une part les performances électriques de la diode, puisque l'injection et le transport de charges seront dégradés, et d'autre part les performances optiques, puisque la cavité optique résonnante d'extraction de lumière s'en trouve « déréglée ». Un but de l'invention est d'éviter ces inconvénients.

L'article intitulé « Electron injection and electroluminescence investigation of OLED devices based on a Sn/Al or Ag/Al cathode", écrit par M M Feng Li, Jing Feng, Gang Cheng, et Shiyong Liu, dans la revue Synthetic Metals, vol.126, no.2-3, pp. 347-350, 14/02/2002, concerne des diodes dont l'électrode supérieure n'est pas transparente, car elle comprend une couche métallique en aluminium qui est trop épaisse (120 nm) pour être transparente ; cette couche métallique n'est pas recouverte d'une couche diélectrique transparente ; ce document indique que l'aluminium, lorsqu'il est utilisé comme couche métallique au contact de la couche organique électroluminescente, a tendance à diffuser dans cette couche, ce qui dégrade les performances de la diode ; pour empêcher cette diffusion au sein de la couche organique, ce document enseigne l'insertion d'une couche métallique tampon, à base d'argent ou d'étain, cette fois, entre la couche métallique et la couche organique électroluminescente. L'électrode supérieure est alors formée de deux couches métalliques empilées. D'autres documents décrivent des électrodes formées d'un empilement de deux couches métalliques, par exemple le document JP09-03587, ou JP11-135265.

### Objet de l'invention

Le but de l'invention est de limiter les réactions entre l'argent de la première couche métallique et le matériau diélectrique pour éviter les dégradations de performances de la diode.

L'invention a donc pour objet une diode organique électroluminescente telle que décrite dans la revendication 1.

La couche organique électroluminescente comprend au moins une sous-couche électroluminescente à proprement parler, et généralement une sous-couche d'injection et de transport de trous entre l'électrode servant d'anode et cette sous-couche électroluminescente, ainsi généralement qu'une sous-couche d'injection et de transport d'électrons entre l'électrode servant de cathode et cette sous-couche électroluminescente. Il est également fréquent de trouver une sous-couche de blocage d'électrons entre la sous-couche d'injection et de transport de trous et la sous-couche électroluminescente, et/ou une sous-couche de blocage de trous entre la sous-couche d'injection et de transport d'électrons et la sous-couche électroluminescente .

La sous-couche électroluminescente est susceptible d'émettre de la lumière lorsqu'un courant parcourt la diode ; la limitation de l'absorption de cette lumière est obtenue comme décrit notamment dans les documents EP1076368, EP1439589 et EP1443572.

Grâce à la deuxième couche métallique à base d'aluminium qui assure une fonction « tampon », on limite les réactions entre l'argent de la première couche métallique et le matériau diélectrique de la couche diélectrique de limitation de l'absorption, ce qui permet avantageusement d'éviter les dégradations de performances de la diode qui résulteraient de ces réactions.

De préférence, le matériau de ladite couche diélectrique est choisi dans le groupe formé par formé par un oxyde transparent conducteur, notamment l'ITO et l'IZO. L'ITO désigne l'oxyde mixte d'indium et d'étain ; l'IZO désigne l'oxyde mixte d'indium et de zinc. Avantageusement, ces matériaux sont conducteurs.

Selon une autre variante, le matériau de ladite couche diélectrique est choisi dans le groupe formé par SiO, ZnS, SnS, TeO2 et SnO2. Ces matériaux sont isolants.

De préférence, l'épaisseur totale de la première et de la deuxième couches métalliques est comprise entre 10 et 40 nm. L'épaisseur de la deuxième couche métallique est comprise entre 3 et 10 nm. On limite ainsi l'absorption de lumière par ces couches.

De préférence, la première électrode est semi-réfléchissante ou réfléchissante. On a donc une cavité optique entre les deux électrodes. De préférence, la distance entre les deux électrodes est adaptée pour optimiser les performances d'extraction de lumière émise par la diode.On a donc une cavité optique résonnante.

L'invention a également pour objet un panneau d'éclairage ou d'affichage d'images comprenant une pluralité de diodes selon l'invention.

### Description détaillée de l'invention

L'invention sera mieux comprise à la lecture de la description qui va suivre, donnée à titre d'exemple non limitatif en référence au dessin annexé dans lequel :
- la figure 1 illustre une vue schématique d'une diode selon l'invention, correspondant à un substrat non transparent adapté à une émission de photons vers le haut », c'est-à-dire au travers de l'électrode supérieure transparente ;
- la figure 2 est une variante de la figure 1, dans laquelle le substrat est transparent, et adapté à une émission de photons vers le bas à travers l'électrode inférieure transparente qui est dans ce cas en contact direct avec le substrat.

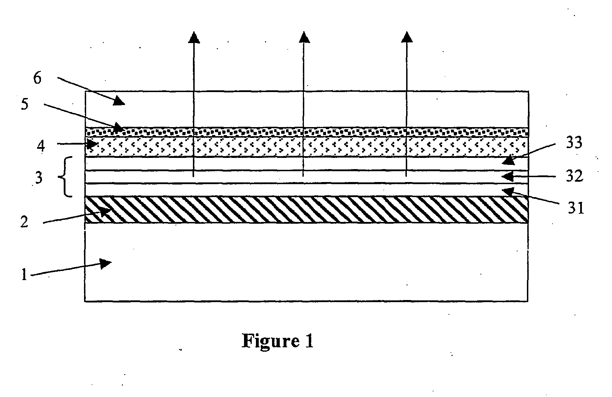

On va maintenant décrire la fabrication d'une diode selon le mode de réalisation de la figure 1.

L'électrode inférieure 2, ici une anode, est déposée sur un substrat 1. Elle est formée par une couche métallique, par exemple en argent, aluminium, voir en or, qui sont des métaux fortement réflecteurs. Cette électrode forme donc ici une couche inférieure réfléchissante. Sur l'électrode 2, on dépose successivement :
- une sous-couche organique en matériau organique semi-conducteur dopé p formant une sous-couche organique d'injection et de transport de trous 31,
- une sous-couche organique en matériau organique dopé en dopant luminescent formant une sous-couche organique électroluminescente 32,
- une sous-couche organique en matériau organique semi-conducteur dopé n formant une sous-couche organique d'injection et de transport d'électrons 33.

Les matériaux et l'épaisseur de ces sous-couches sont connus en eux-mêmes, par exemple des documents EP0498979, EP1017118, US6013384, US6433355 et WO02/41414

L'empilement des sous-couches 31 à 33 forme la couche organique électroluminescente 3.

Sur cet empiiement, on dépose une première couche métallique 4, ici en argent, et une deuxième couche métallique 5, en aluminium. Bien que l'argent ne soit pas réputé comme très performant pour l'injection des électrons dans la couche organique 3, on peut l'utiliser quand même à cet effet, grâce à l'emploi d'une sous-couche organique dopée n 33 au contact de cette première couche 4 ; l'argent est préféré à l'aluminium, qui est moins transparent et moins réflecteur que l'argent. L'épaisseur totale de la première couche 4 et de la deuxième couches métalliques 5 est de préférence comprise entre 10 et 40 nm, en fonction, notamment du meilleur compromis entre :
- une transparence suffisamment élevée à la lumière émise par la couche électroluminescente, qui est favorisée par la couche diélectrique 6 ultérieurement déposée ;
- une conductivité suffisamment élevée pour l'injection des électrons dans la couche organique sous-jacente 3 ;
- et la fonction semi-réfléchissante requise pour l'obtention de la cavité optique entre l'électrode inférieure et l'électrode supérieure.

L'aluminium et l'argent sont avantageusement utilisés comme base de l'électrode supérieure, parce qu'ils présentent tous les deux une conductivité électrique élevée. Cette électrode supérieure est ici une cathode. Cependant, comme l'aluminium présente intrinsèquement une transparence beaucoup plus faible que l'argent à la lumière émise par la couche électroluminescente, on cherche à minimiser l'épaisseur de la deuxième couche métallique 5 par rapport à celle de la première couche métallique 4. L'épaisseur de la couche d'aluminium est comprise entre 3 et 10 nm ; au-delà de 10 nm, les pertes par absorption de lumière émise dans cette couche sont en général trop élevées ; en deçà de 3 nm, la fonction « tampon » de la couche d'aluminium, précisée ci-après, n'est plus, en général, suffisamment efficace. Ainsi, l'épaisseur de la première couche métallique 4 est supérieure à l'épaisseur de la deuxième couche métallique 5.

Sur la double couche métallique ainsi obtenue, on dépose, par exemple par pulvérisation cathodique sous vide, une couche diélectrique 6 par exemple de SiO, ou de toute autre matière; l'épaisseur de cette couche 6 est de préférence adaptée pour réduire l'absorption des couches métalliques sous-jacentes 4 et 5, voire pour optimiser les performances d'extraction et de colorimétrie apportée par la cavité optique formée entre l'électrode inférieure réfléchissante et l'électrode supérieure semi-réfléchissante ; l'épaisseur de cette couche diélectrique 6 peut contribuer à la protection (fonction « encapsulation ») de la couche organique sous-jacente 3 contre les risques de détérioration par l'oxygène et ou l'humidité ambiantes. Lorsque le matériau diélectrique de cette couche est notamment l'ITO, elle peut contribuer à la conductivité de l'électrode supérieure.

On obtient alors une diode selon le premier mode de réalisation de l'invention illustré à la figure 1. Grâce à la deuxième couche métallique 5 en aluminium qui assure une fonction « tampon » entre l'argent de la première couche métallique 4 et le matériau de la couche supérieure diélectrique transparente 6, on limite les réactions chimiques entre ces couches 4 et 6, ce qui permet d'éviter la dégradation des performances de la diode, et ce qui facilite l'optimisation de la cavité optique entre les électrodes. Parallèlement, on constate que le procédé de fabrication est beaucoup plus reproductible.

L'hypothèse de la fonction « tampon » de la couche d'aluminium est étayée par les constatations suivantes :
- une diode dont l'électrode supérieure ne comprend qu'une seule couche métallique en aluminium fonctionne, même si l'épaisseur de cette couche est très faible et de l'ordre de 5 nm ; ceci illustre l'absence de réaction chimique entre l'aluminium et le matériau de la couche supérieure diélectrique transparente 6, notamment lorsque ce matériau est un oxyde ;
- une diode dont l'électrode supérieure ne comprend qu'une seule couche métallique en argent ne fonctionne pas lorsque l'épaisseur de cette couche est inférieure ou égale à 10 nm ; ceci est attribué à une réaction chimique entre l'argent et le matériau de la couche supérieure diélectrique transparente 6, observée notamment lorsque ce matériau est un oxyde.

On a constaté par ailleurs que la fonction « tampon » assurée par l'aluminium selon l'invention était aussi efficace que la fonction tampon assurée par d'autres matériaux, notamment par un métal tel que Ti, Cr, Ta, ou d'un nitrure de ces métaux, tels que décrits dans le document US5969474 déjà cité. Un avantage important de l'aluminium est qu'il peut être déposé sous vide à basse température (basse température de sublimation : 700°C).

D'autres variantes de l'invention peuvent être envisagées sans se départir de l'invention, notamment une couche supérieure formée de plusieurs sous-couches de différents matériaux diélectriques transparents, par exemple d'une sous-couche à base de SiO et d'une sous-couche à base d'ITO.

On peut utiliser des matériaux organiques non dopés pour l'injection et le transport de charges (sous-couches 31 et 33) sans se départir de l'invention. Sans se départir de l'invention, on peut également ajouter des sous-couches de blocage de charges entre les sous-couches d'injection et de transport 31, 33 et la sous-couche électroluminescente 32.

L'invention a été décrite dans le cas d'une diode qui émet « vers le haut », c'est-à-dire au travers de son électrode supérieure.

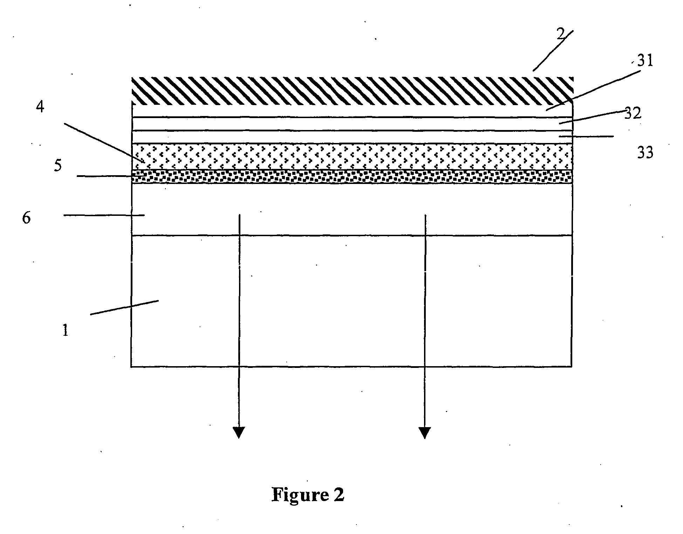

Sur la figure 2, l'invention s'applique également aux diodes émettant « vers le bas », c'est-à-dire au travers de leur électrode inférieure (et donc de leur substrat 1 qui est dans ce cas transparent). L'électrode inférieure est aussi transparente et comprend les deux couches métalliques 4, 5 et la couche diélectrique 6, laquelle est en contact direct avec le substrat 1.

L'invention s'applique également aux diodes dites « transparentes » qui émettent à la fois vers le haut et vers le bas.

L'invention est applicable à tout type de diode organique électroluminescente et aux panneaux d'éclairage ou d'affichage utilisant de telles diodes.

## Revendications

1. Diode organique électroluminescente comprenant un substrat (1), une couche organique (3) électroluminescente agencée entre une première électrode (2) et une deuxième électrode transparente et semi-refléchissante à structure multicouches subdivisée en:
- une première couche métallique (4) à base d'argent en contact avec la couche organique (3) électroluminescente,
- une couche diélectrique (6),
la couche organique (3) électroluminescente comportant une sous-couche dopée de type n en contact avec avec la première couche métallique (4) de la deuxième électrodes transparente,
diode électroluminescente **caractérisée en ce qu'**une deuxième couche métallique (5) d'épaisseur comprise entre 3 et 10nm, à base d'aluminium, est intercalée entre la première couche métallique (4) et la couche diélectrique (6) de la deuxième électrode transparente, l'épaisseur de la première couche métallique (4) étant supérieure à l'épaisseur de la deuxième couche métallique (5), et **en ce que** l'épaisseur de ladite couche diélectrique (6) est adaptée pour limiter l'absorption par lesdites première (4) et deuxième (5) couches métalliques de la lumière émise par la diode.

2. Diode organique électroluminescente selon la revendication 1 et à émission de photons à travers le substrat, **caractérisée en ce que** le substrat (1) est transparent, et que la couche diélectrique (6) de la deuxième électrode transparente se trouve en contact direct avec le substrat (1),

3. Diode organique électroluminescente selon la revendication 1 et à émission de photons par la face supérieure, **caractérisée en ce que** le substrat (1) est non transparent, et que la couche diélectrique (6) de la deuxième électrode transparente se trouve au sommet de l'empilage à l'opposé du substrat.

4. Diode selon l'une quelconque des revendications 1 à 3 **caractérisée en ce que** le matériau de ladite couche diélectrique (6) est choisi dans le groupe formé par par un oxyde transparent conducteur, notamment l'ITO et l'IZO.

5. Diode selon l'une quelconque des revendications 1 à 3 **caractérisée en ce que** le matériau de ladite couche diélectrique (6) est choisi dans le groupe formé SiO, ZnS, SnS, Te02 et SnO2.

6. Diode selon l'une quelconque des revendications précédentes, **caractérisée en ce que** l'épaisseur totale de la première (4) et de la deuxième (5) couches métalliques est comprise entre 10 et 40 nm.

7. Diode selon l'une quelconque des revendications précédentes, **caractérisée en que** la première électrode (2) est semi-réfléchissante ou réfléchissante.

8. Diode selon la revendication 7, **caractérisée en ce que** la distance entre les première et deuxième électrodes est adaptée pour optimiser les performances d'extraction de lumière émise par la diode.

9. Panneau d'éclairage ou d'affichage d'images **caractérisé en ce qu'**il comprend une pluralité de diodes selon l'une quelconque des revendications précédentes.

## Claims

1. An organic light-emitting diode comprising a substrate (1), an organic light-emitting layer (3) arranged between a first electrode (2) and a transparent and semi-reflecting second electrode with a multilayer structure subdivided into:
- a first silver-based metallic layer (4) in contact with the organic light-emitting layer (3),
- a dielectric layer (6),
the organic light-emitting layer (3) comprising a n-doped sub-layer in contact with the first metallic layer (4) of the transparent second electrode,
diode **characterized in that** a second aluminium-based metallic layer (5) of thickness comprises between 3 and 10nm is inserted between the first metallic layer (4) and the dielectric layer (6) of the transparent second electrode, the thickness of the first metallic layer (4) being larger than the thickness of the second metallic layer (5), and that the thickness of said dielectric layer (6) is adjusted to limit the absorption by said first (4) and second (5) metallic layers of the light emitted by the diode.

2. The diode according to claim 1 and with photon emission via the substrate, **characterized in that** the substrate (1) is transparent, and that the dielectric layer (6) of the transparent second electrode is in direct contact with the substrate (1).

3. The diode according to claim 1 and with photon emission via the top face, **characterized in that** the substrate (1) is non-transparent, and that the dielectric layer (6) of the transparent second electrode is located at the top of the stack opposite from the substrate.

4. The diode according to any one of claims 1 to 3 **characterized in that** the material of said dielectric layer (6) is chosen from the group formed by a transparent conducting oxide, in particular ITO and IZO.

5. The diode according to any one of claims 1 to 3 **characterized in that** the material of said dielectric layer (6) is chosen from the group formed by SiO, ZnS, SnS, TeO2 and Sn02.

6. The diode according to any one of the foregoing claims **characterized in that** the total thickness of the first (4) and second (5) metallic layers is comprised between 10 and 40 nm.

7. The diode according to any one of the foregoing claims **characterized in that** the first electrode (2) is semi-reflecting or reflecting.

8. The diode according to claim 7 **characterized in that** the distance between the first and second electrodes is adjusted to optimize the extraction performances of light emitted by the diode.

9. A lighting or image display panel **characterized in that** it comprises a plurality of diodes according to any one of the foregoing claims.

## Patentansprüche

1. Organische Leuchtdiode mit einem Substrat (1), wobei eine organische Leuchtschicht (3) zwischen einer ersten Elektrode (2) und einer zweiten, transparenten und halbreflektierenden Elektrode mit mehrschichtigem Aufbau ausgeführt ist, welcher unterteilt ist in:
- eine erste metallische Schicht (4) auf Silberbasis, die sich in Kontakt mit der organischen Leuchtschicht (3) befindet,
- eine dielektrische Schicht (6),
wobei die organische Leuchtschicht (3) eine dotierte Unterschicht des Typs n enthält, die sich in Kontakt mit der ersten metallischen Schicht (4) der zweiten, transparenten Elektrode befindet,
**dadurch gekennzeichnet,**
**dass** eine zweite metallische Schicht (5) mit einer Stärke von 3 bis 10nm auf Aluminiumbasis zwischen der ersten metallischen Schicht (4) und der dielektrischen Schicht (6) der zweiten, transparenten Elektrode angeordnet ist, wobei die Stärke der ersten metallischen Schicht (4) größer ist als die Stärke der zweiten metallischen Schicht (5), und dass die Stärke der genannten dielektrischen Schicht (6) dazu geeignet ist, die Absorption des von der Diode ausgesendeten Lichts durch diese erste und zweite metallische Schicht (4, 5) zu begrenzen.

2. Organische Leuchtdiode nach Anspruch 1 und zur Emission von Photonen durch das Substrat hindurch,
**dadurch gekennzeichnet,**
**dass** das Substrat (1) transparent ist und dass sich die dielektrische Schicht (6) der zweiten, transparenten Elektrode in direktem Kontakt mit dem Substrat (1) befindet.

3. Organische Leuchtdiode nach Anspruch 1 und zur Emission von Photonen durch die Oberseite,
**dadurch gekennzeichnet,**
**dass** das Substrat (1) nicht transparent ist und dass sich die dielektrische Schicht (6) der zweiten, transparenten Elektrode oben auf dem Stapel, entgegengesetzt zum Substrat befindet.

4. Diode nach einem der Ansprüche 1 bis 3,
**dadurch gekennzeichnet,**
**dass** der Werkstoff der dielektrischen Schicht (6) aus der Gruppe gewählt ist, die von einem leitenden, transparenten Oxid, insbesondere ITO und IZO, gebildet wird.

5. Diode nach einem der Ansprüche 1 bis 3,
**dadurch gekennzeichnet,**
**dass** der Werkstoff der dielektrischen Schicht (6) aus der Gruppe gewählt ist, die von SiO, ZnS, SnS, TeO₂ und SnO₂ gebildet wird.

6. Diode nach einem der vorigen Ansprüche,
**dadurch gekennzeichnet,**
**dass** die Gesamtstärke der ersten und der zweiten metallische Schicht (4, 5) zwischen 10 und 40 nm beträgt.

7. Diode nach einem der vorigen Ansprüche,
**dadurch gekennzeichnet,**
**dass** die erste Elektrode (2) halbreflektierend oder reflektierend ist.

8. Diode nach Anspruch 7,
**dadurch gekennzeichnet,**
**dass** der Abstand zwischen der ersten und der zweiten Elektrode darauf eingestellt ist, die Leistungen der Lichtausbeute des von der Diode emittierten Lichts zu optimieren.

9. Beleuchtungstafel oder Anzeigetafel für Bilder,
**dadurch gekennzeichnet,**
**dass** sie eine Vielzahl von Dioden nach einem der vorigen Ansprüche aufweist.
